# EUROPEAN PATENT APPLICATION

(11) **EP 4 559 888 A1**
(43) Date of publication of application: **28.05.2025**
(21) Application number: 23842623.3
(22) Date of filing: 15.03.2023
(51) Int. Cl.: C04B 41/87, C23C 14/08

(54) **SAND AND DUST RESISTANT FILM**

(30) Priority: 22.07.2022 JP 2022116970
(71) Applicant: IHI Corporation, Tokyo 135-8710 (JP)
(72) Inventor: YAMAZAKI Naoki, Tokyo 135-8710 (JP); KANAZAWA Shingo, Tokyo 135-8710 (JP); TANAKA Yuta, Tokyo 135-8710 (JP); HOSOYA Nagisa, Tokyo 135-8710 (JP); NAKAMURA Takeshi, Tokyo 135-8710 (JP); KITAOKA Satoshi, Nagoya-shi, Aichi 456-8587 (JP); TANAKA Makoto, Nagoya-shi, Aichi 456-8587 (JP); KAWASHIMA Naoki, Nagoya-shi, Aichi 456-8587 (JP); ITO Taishi, Nagoya-shi, Aichi 456-8587 (JP)
(74) Representative: MERH-IP Matias Erny Reichl Hoffmann Patentanwälte PartG mbB
(86) International application number: PCT/JP2023/010057
(87) International publication number: WO 2024/018686

(57) **Abstract**

A coating for protecting a ceramic-matrix composite against a high-temperature environment including dust is provided with a top layer of a substance represented by a formula a(ReO_{1.5})b(AlO_{1.5})c(TrO₂) as an average composition at least on a face exposed to the environment, wherein a, b and c satisfy 1>a≥0.5, b>0 and c=1-(a+b), Re is one or more selected from rare earth elements, and Tr is Hf or Zr.

## Description

### TECHNICAL FIELD

The present disclosure relates to a coating that protects a subject body against a high-temperature environment, which is particularly protective in a case where the subject body is exposed to a high-temperature atmosphere including some substances such as dust that would melt at high temperature.

### BACKGROUND ART

Engineers in the field of gas turbines continue to make efforts in raising the operating temperatures in order to improve energy efficiency. Its turbine blades and nozzles have been of nickel superalloys in the past and engine operation up to 1100 degrees C level has been thereby realized. Ceramic-matrix composites (CMCs) are recently used in place of the nickel superalloys and further environmental barrier coatings (EBCs) such as stabilized zirconia are used in order to prevent steam oxidation, thereby enabling operation at 1200 degrees C level.

At higher temperatures, 1300 degrees C level for example, new issues would be allegedly come to the surface. More specifically, the air taken into the gas turbines inevitably contains micro particles such as dust, which in turn contains components such as calcia, magnesia, alumina and silica (collectively, CMAS). It is expected that CMAS produce a liquid phase above 1240 degrees C, which would react with and thereby corrode the EBC (CMAS attack). Degradation of turbines by dust may become prominent particularly in airplanes flying over desert areas.

It is keenly studied to add any top coatings over the EBCs in order to protect the EBC against the CMAS attack. The patent literature 1 discloses a related art.

### Citation List

### Patent Literature

PTL 1: PCT International Publication WO 2009/085572

### SUMMARY OF THE INVENTION

Alumina partially replaced with rare-earth oxides such as yttria is reported to, on contact with molten CMAS, react therewith and raise the melting point of CMAS, thereby making it less likely to produce a liquid phase. This is thus promising as a candidate for the top coating that protects the EBC but is in turn open to question on the issue of the long-term protection ability because the reaction consumes this substance itself. The coating disclosed hereinafter has been studied in order to solve this problem.

According to the present disclosure, a coating for protecting a ceramic-matrix composite against a high-temperature environment including dust is provided with a top layer of a substance represented by a formula a(ReO_{1.5})b(AlO_{1.5})c(TrO₂) as an average composition at least on a face exposed to the environment, wherein a, b and c satisfy 1>a≥0.5, b>0 and c=1-(a+b), Re is one or more selected from rare earth elements, and Tr is Hf or Zr.

Preferably, aluminum in the substance forms one or more chemical compounds selected from Re₄Al₂O₉, ReAlO₃ and Re₃Al₅O₁₂. More preferably, a, b and c further satisfy a formula of S_{A}/S₀≥0.1 or S_{A}/S₀≥0.2 wherein S_{A}/S₀ is an area ratio of a region where a mixture of apatite and garnet is stable to a region from Ca/Si=0.11 to Ca/Si=1.5 on a phase diagram for a system of CMAS and the substance at 1500 degrees C. Still preferably, b further satisfies a formula of b>0.2. Alternatively preferably, Re is one or more selected from Yb and Lu, and Tr is Hf.

### EFFECTS OF THE INVENTION

The disclosed art provides a coating capable of protecting ceramic-matrix composites against a high-temperature environment including dust over a long term.

### BRIEF DESCRIPTION OF THE DRAWINGS

FIG. 1 is a schematic sectional view of a ceramic-matrix composite coated with a top coating and an environmental barrier coating in accordance with an embodiment.
FIG. 2 is a schematic drawing for explaining a device for producing a coating by an electron beam physical vapor deposition method.
FIG. 3A is a schematic sectional view for explaining a state where a deposit including CMAS adheres to the coating.
FIG. 3B is a schematic sectional view for explaining a state where reaction between the deposit and the top coating has produced a protective coating.
FIG. 4 is a ternary phase diagram for a system of silica-rich CMAS, calcia-rich CMAS and an EBC composition.
FIG. 5 is a schematic plan view for showing a typical appearance of a simulated deposit on a sintered body.
FIG. 6A is a sectional SEM image of a sintered body of an ytterbia-alumina-zirconia system after a corrosion test, showing an example where the test yielded a relatively thin and dense reacted layer.
FIG. 6B is a sectional SEM image of a sintered body of an ytterbia-alumina system after a corrosion test, showing an example where the test yielded a coarse reacted layer.
FIG. 6C is another example of a sectional SEM image of a sintered body of an ytterbia-alumina-zirconia system after a corrosion test.
FIG. 6D is an example of a sectional SEM image of a sintered body of a ruthenia-alumina-zirconia system after a corrosion test.
FIG. 6E is an example of a sectional SEM image of a sintered body of an yttria-alumina-zirconia system after a corrosion test.
FIG. 6F is an example of a sectional SEM image of a sintered body of a gadolinia-alumina-zirconia system after a corrosion test.
FIG. 6G is an example of a sectional SEM image of a sintered body of a samaria-alumina-zirconia system after a corrosion test.
FIG. 7A is a schematic sectional view of a test piece for explaining a method for measuring a thickness of a reacted layer.
FIG. 7B is a schematic sectional view of a test piece, showing an example including secondary crystallization.
FIG. 8 is a drawing where results of the corrosion test are plotted on a ternary diagram for a hafnia-ytterbia-alumina system.

### DESCRIPTION OF EMBODIMENTS

Certain embodiments will be described hereinafter with reference to the appended drawings.

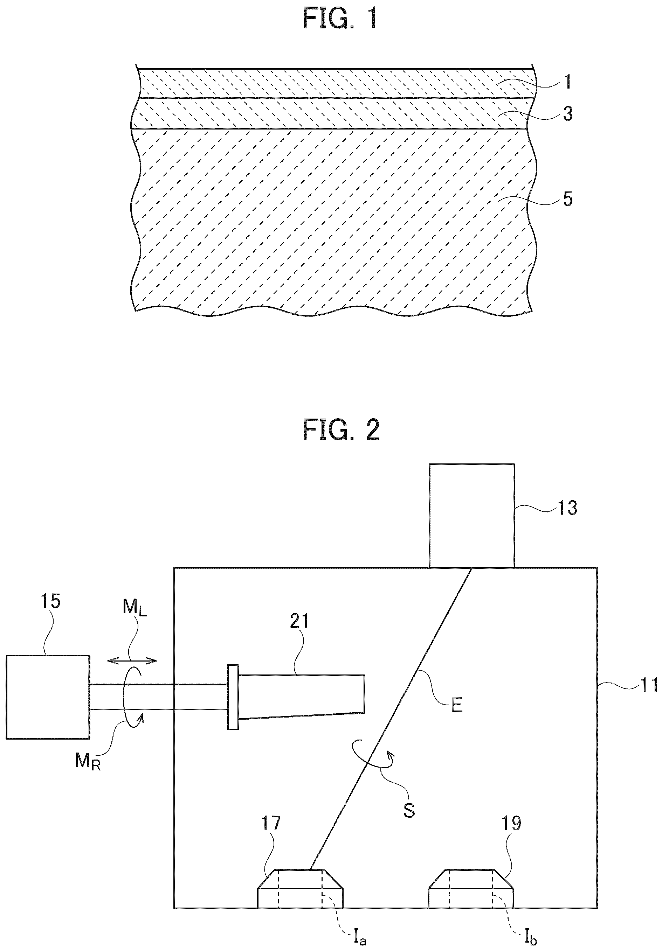

A coating of the present embodiment is preferably used for the purpose of protecting a subject body against an environment, where the subject body may be a stator vane or a rotor blade of a gas turbine used in a high-temperature environment for example. Referring to FIG. 1, a substrate 5 of the subject body is covered with an environmental barrier coating (EBC) 3 for example, and its surface is further covered with an anti-dust coating 1.

The substrate 5 is of a ceramic matrix composite (CMC) for example. The CMC is for example of reinforcement fibers of a ceramic such as silicon carbide and a matrix forming a composite with the reinforcement fibers to combine these fibers together. The reinforcement fibers may be of another ceramic instead of silicon carbide. The matrix is mainly of a ceramic that is common with the reinforcement fibers but may be of another ceramic instead. The present embodiment is, however, not limited to CMC but may be applicable to any publicly-known material or any still unknown material.

The environmental barrier coating 3 is of a material having an ability of shielding the substrate 5 from the environment. The material is beneficial in shielding the substrate 5 from a corrosive atmosphere such as high-temperature steam to prevent its oxidization. The material is, still preferably, sufficiently close in thermal expansion coefficient to the substrate 5. This is to prevent exfoliation of the environmental barrier coating 3 from the substrate 5 by thermal expansion/contraction. The environmental barrier coating 3 may be, however, directed not to prevention of steam oxidation but to another purpose, and therefore the material may have another ability additionally or alternatively.

To the environmental barrier coating 3, rare-earth silicates such as ytterbium silicate, silicates such as mullite (aluminosilicate), or transition metal oxides such as zirconia or hafnia are preferably applicable. As an example for zirconia can be so-called stabilized-zirconia to which an oxide of a rare earth element such as yttrium is added so as to stabilize its cubic crystal. In between the barrier-performable substance and the substrate 5, any intermediate layer such as silicon can be interposed to relieve difference in thermal expansion coefficient. Or, instead of or in addition to them, barium strontium aluminosilicate (BSAS) may be applied to the environmental barrier coating 3.

The anti-dust coating 1 is mainly used for the purpose of protecting the environmental barrier coating 3 and the substrate 5 against a high-temperature environment including dust. Of course, it is not intended to exclude any other purposes.

While details about its composition will be described later, the anti-dust coating 1 is generally of a mixture of a rare-earth oxide, alumina and a transition metal oxide, which fuse together partly or totally to form sinter, multi compound or mixed oxide. This substance may be alternatively represented as a composition a(ReO_{1.5})b(AlO_{1.5})c(TrO₂), where a>0, b>0, c>0 and a+b+c=1, Re is one or more selected from rare earth elements, and Tr is any transition element or in particular a group 4 transition element such as Hf or Zr.

The anti-dust coating 1 may be formed by an electron beam physical vapor deposition method (EBPVD) using a device illustrated in FIG. 2 for example. The chamber 11 is so structured as to keep its interior in a high-vacuum state. Further, an actuator 15 is coupled to the chamber 11 to support a subject body 21 within the chamber 11 and further make it controllably into a linear motion ML and a rotational motion MR. In the chamber 11 as well, an electron beam gun 13 and a first crucible 17 are installed and so structured that an electron beam E is drawn out and led to the first crucible 17 when potential difference is given therebetween. A first ingredient Iₐ in the crucible 17 is thereby irradiated by the electron beam E. The electron beam gun 13 is further so structured as to scan the electron beam E as shown by an arrow S, thereby heating and evaporating the first ingredient Iₐ in an unbiased fashion to adhere the vapor onto the subject body 21. The device may be further provided with a second crucible 19 holding a second ingredient I_{b}. By operating them alternately, a multi-layer coating consisting of mutually different substances may be continuously formed. Of course, the device may be provided with three or more crucibles to form a multi-layer coating consisting of three or more substances.

A mixture in which powders respectively of a rare-earth oxide, alumina and a transition element metal oxide are mixed together for example is applicable to the first ingredient Iₐ. This is loaded in the first crucible 17 and CMC is in advance formed into a shape of a rotor blade for example as the subject body 21, these bodies are introduced into the device and the EBPVD is executed, thereby producing the anti-dust coating 1 on the surface. Prior to the formation of the anti-dust coating 1, of course, by using the second crucible 19, the environmental barrier coating 3 may be in advance formed. More specifically, the environmental barrier coating 3 and the anti-dust coating 1 can be produced in series.

Of course, not limited to the EBPVD, another publicly-known method such as spraying using arc discharge for example may be used. Or, two or more methods may be used in combination. While the EBPVD generally creates a columnar crystal, the spraying may create a lamellar structure, thereby creating some differences in exfoliation and covering properties.

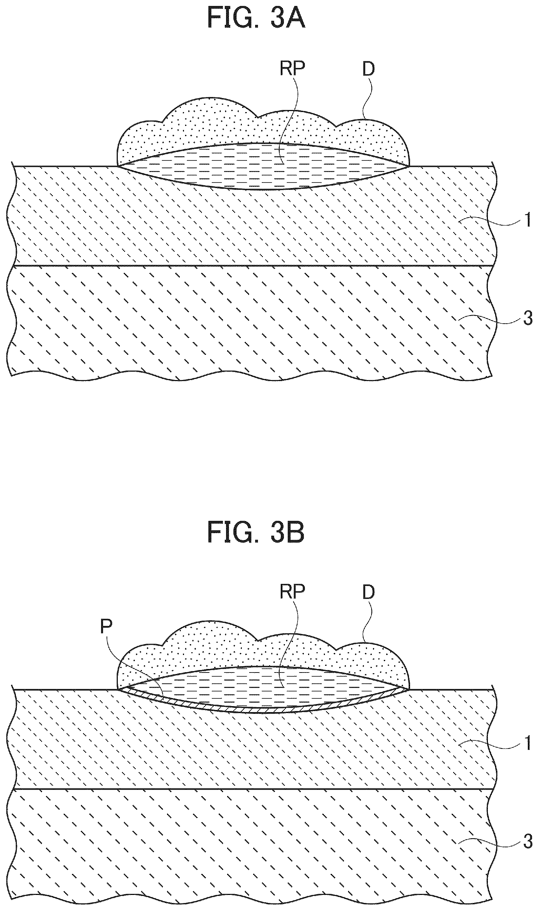

Referring to FIG. 3A, when high-temperature air including impurities such as the dust is in contact with the coating, a part of the impurities adheres to the coating and then forms a deposit D thereon. If the temperature of the deposit D rises above 1240 degrees C, calcia, magnesia, alumina and silica (collectively, CMAS) contained therein start melting and partly react with the coating to form a product RP. If the melting point of the product RP is below the environmental temperature, it is left in a liquid phase and therefore the reaction with the coating further progresses, and the liquid will intrude through small cracks, if any, into the coating and eventually reach and corrode the environmental coating. As alumina partially replaced with rare-earth oxides such as yttria raises the melting point of CMAS and thus reduces the liquid phase as described already, it is beneficial in preventing the CMAS from reaching the environmental barrier coating. The coating itself would, however, be consumed and instead the liquid phase would be repetitiously supplied, and therefore long-term protection for the environmental coating cannot be expected.

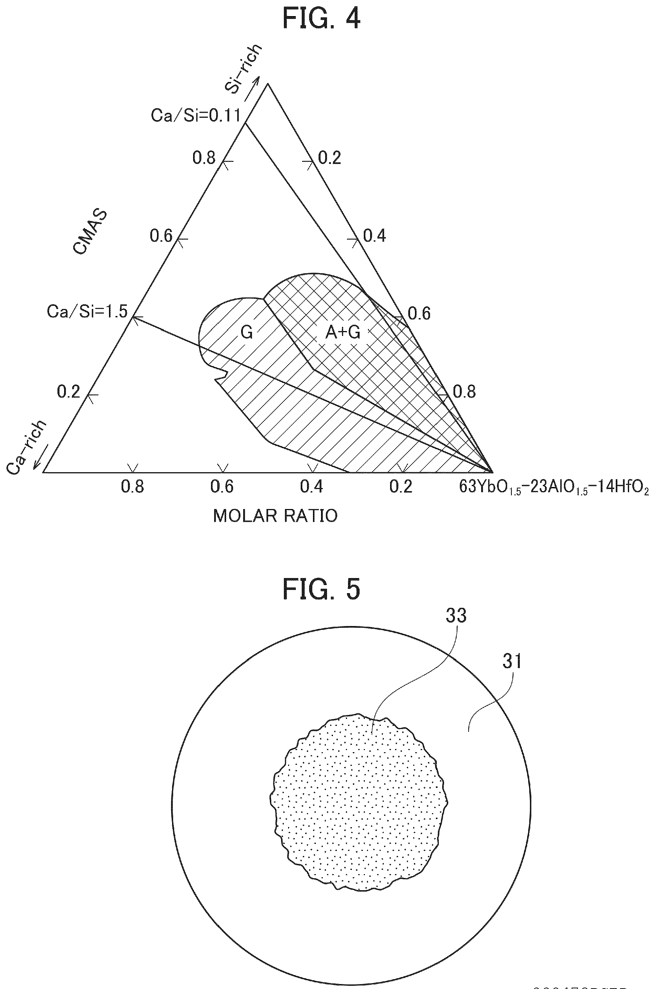

The anti-dust coating 1 according to the present embodiment, as its chemical composition is so designed, reacts with the CMAS to form a protective product P that remains solid even at high-temperatures. Details will be described below with reference to FIG. 4.

FIG. 4 is a phase diagram obtained by a software for thermodynamic equilibrium calculation available under the name of "Fact Sage ver. 8.1" (GTT Technologies) from the assumption that the total pressure is 10⁵ Pa, the oxygen partial pressure is 0.2x10⁵ Pa, and the temperature is 1500 degrees C. In this calculation, the composition of the coating is supposed to be [YbO_{1.5}] : [AlO_{1.5}] : [HfO₂]=63:23:14, which corresponds to the apex in the lower right. The hypotenuse in the upper left corresponds to CMAS ((SiO₂,CaO)-6MgO-6FeO_{1.5}-18AlO_{1.5}). As the ratio of SiO₂ to CaO in the CMAS can vary over a considerable range, FIG. 4 is drawn as a quasi-ternary phase diagram with the top apex as a Si-rich composition (0.7SiO₂,0.3CaO)-6MgO-6FeO_{1.5}-18AlO_{1.5}) and the lower-left apex as a Ca-rich composition (0.3SiO₂,0.7CaO)-6MgO-6FeO_{1.5}-18AlO_{1.5}). Further, to simplify the drawing, only three regions are drawn, one of which includes a liquid phase, another of which includes apatite as a solid phase, and the other of which includes garnet as another solid phase.

It is understood that, in a region close to the upper-left hypotenuse (meaning that the CMAS is dominant and a small amount of components soaks in it from the coating), a liquid phase is dominant but, in a region close to the lower-right hypotenuse (meaning that the components soaking from the coating are more influential), apatite or garnet, or both, crystallizes out. Which of them crystals out and how wide the crystallization occurs depend on the composition of the coating. In a case where the coating is only of alumina for example, liquid phases occupy most areas in the phase diagram at 1500 degrees C, whereas apatite can crystal out in considerable areas if the coating is of ytterbium silicate. As illustrated in FIG. 4, in a case where the coating is of a composition of ytterbia, alumina and hafnia, the areas where apatite and garnet can crystal out become larger and as well mutually overlap.

While apatite, if alone, can be expected to achieve the protection ability against the CMAS, the present inventors have found that coexistence of garnet with apatite would prominently improve the protection ability. Further, if the composition of the coating makes larger the region where garnet coexists with apatite, it is expected that slight elution of the coating can cause generation of the protective product and therefore elongate the protective ability. Then the inventors have carried out calculations again and again about various coating compositions to find compositions that make larger the region where garnet coexists with apatite. The inventors have particularly focused on an ratio S_{A}/S₀ of an area S_{A} of the region where a mixture of apatite and garnet is stable to an area S₀ from Ca/Si=0.11 to Ca/Si=1.5 on the phase diagram, and have sought compositions increasing S_{A}/S₀ (specifically, promoting crystallization of apatite and garnet).

The present inventors, on the basis of the aforementioned studies, have reached mixtures of a rare-earth oxide, alumina and a transition metal oxide. The composition in question can be represented by a formula a(ReO_{1.5})b(AlO_{1.5})c(TrO₂), where a>0, b>0, c>0 and a+b+c=1, Re is one or more selected from rare earth elements, and Tr is any transition element or in particular a group 4 transition element such as Hf or Zr.

If ReO_{1.5} sufficiently reacts with AlO_{1.5} in the coating, they constitute complex oxides. Particularly, if a mole fraction of ReO_{1.5} to AlO_{1.5} is 0.5 or higher, AlO_{1.5} does not exist but is expected to form any one or more chemical compounds of Re₄Al₂O₉, ReAlO₃ and Re₃Al₅O₁₂. ReAlO₃ among them tends to decompose below 1730 degrees C and thus gives rise to structural damage to the coating by temperature change accompanied by phase transition. Accordingly, to improve thermodynamic stability of ReAlO₃, any additional elements may be further added to the coating. Gd and Nd can be listed among such examples and may be added in the form of these oxides to the coating.

To test CMAS attack resistance of these compositions, the following tests were carried out.

Powders of various oxides were mixed in various ratios, subject to press-forming at normal temperature to form disk-like compacts of 20 mmϕ x 4 mm^{t}, and these compacts were sintered at 1500 degrees C for 50 hours to obtain disk-like sintered bodies 31. They could simulate coatings. On the other hand, CaO, MgO, Fe₂O₃, Al₂O₃ and SiO₂ were mixed in a composition of CaO33MgO5FeO_{1.5}5AlO_{1.5}19SiO₂38 (at%) and kneaded in a paste-like form to form simulated CMAS 33. This could simulate CMAS adhering to the coating. The simulated CMAS 33 was applied respectively to a plurality of sintered bodies 31 as shown in FIG. 5 and they were subject to a heating test at 1400 degrees C for 7 hours. Test pieces after heating were naturally cooled, cut and embedded in resin, and respectively subject to sectional observation by scanning electron microscopy (SEM).

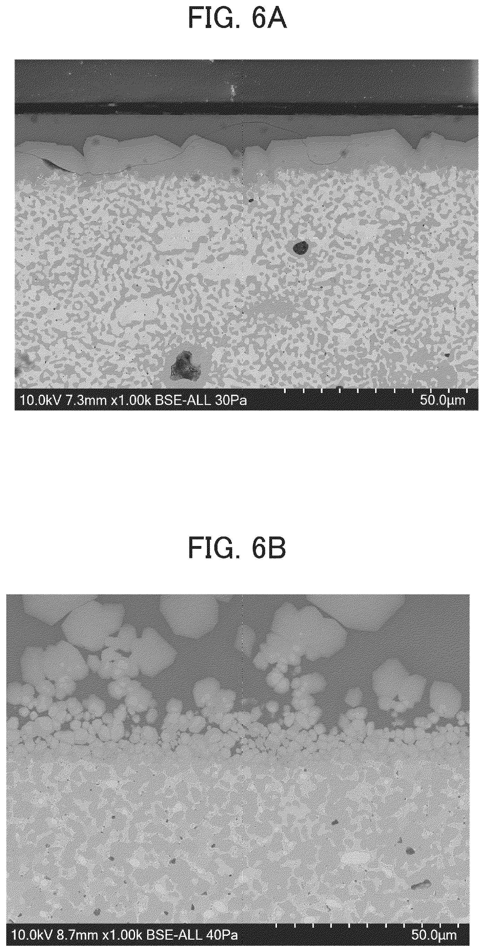

Examples of sectional SEM images are shown in FIGs. 6A through 6G. It can be determined that regions with lightly gray spotted patterns shown around the lower halves of the images are the sintered bodies, and relatively narrow, darker gray, regions closely above the former regions are layers reacted with CMAS, and further darker gray regions still above these regions are solids that may originate from liquids of CMAS being cooled and solidified.

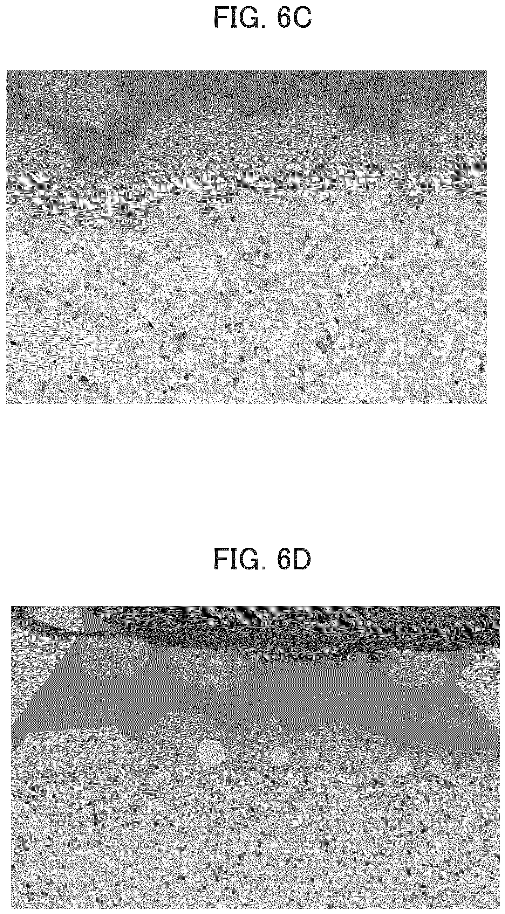

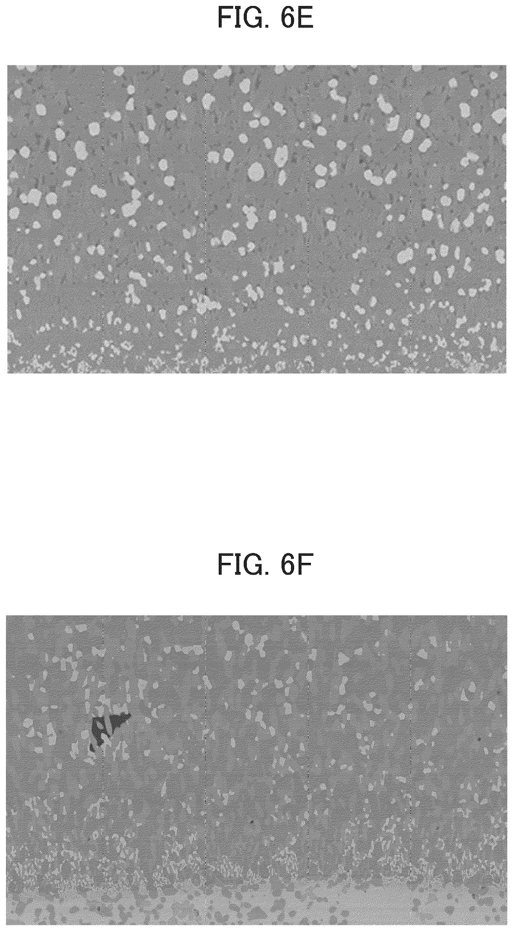

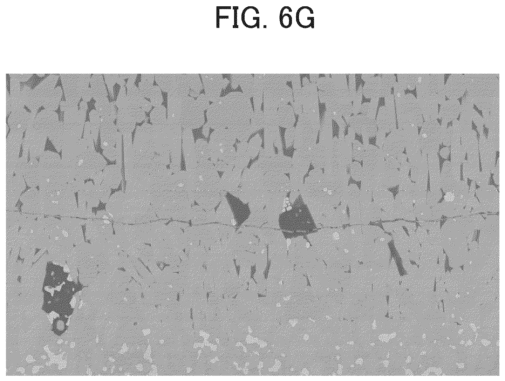

The sintered body including ytterbia, alumina and zirconia, as shown in FIG. 6A, exhibits a thin dense reacted layer, which is expected to have excellent CMAS-attack resistance. On the other hand, the sintered body not including zirconia, as shown in FIG. 6B, exhibits a thin but coarse reacted layer and as well lumps in the CMAS region, which resemble the reacted layer. These lumps are considered to originate from a liquid phase that could be secondarily crystalized in the course of cooling into a composition similar to the reacted layer. Considering its structure, even though the reacted layer is thin, the coating is expected to be inferior in light of the CMAS-attack resistance. Even a sintered body including ytterbia, alumina and zirconia, depending on its composition, happened to create a relatively thick reacted layer as shown in FIG. 6C. The reacted layer becomes relatively thin as shown in FIG. 6D where ytterbia is replaced with ruthenia, whereas, in cases where ytterbia is replaced with yttria (FIG. 6E), gadrinia (FIG. 6F) and samaria (FIG. 6G), reacted layers may tend to become relatively thicker.

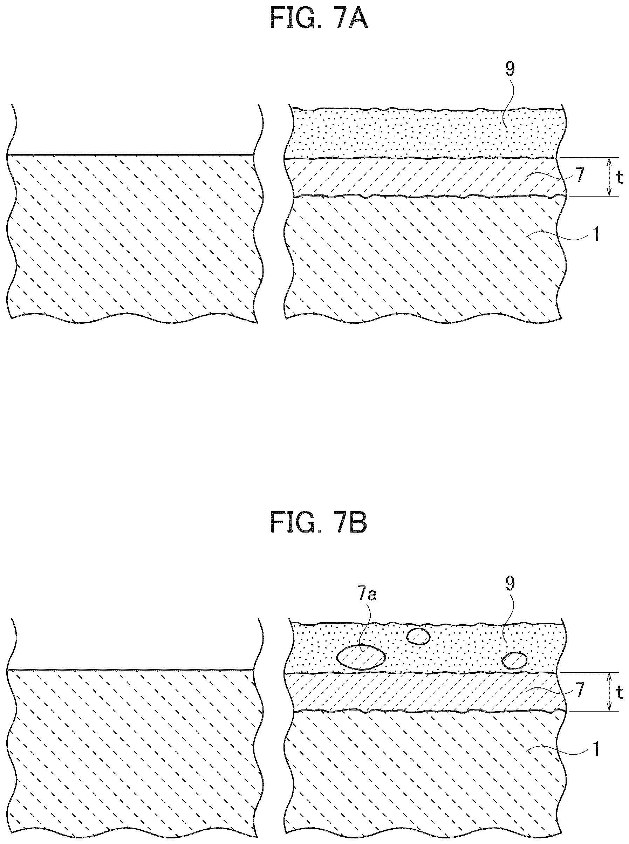

When the visual range subject to observation is moved to a site where the original surface of the sintered body is left, as illustrated in FIG. 7A, the surface of the reacted layer 7 and the original surface of the sintered body 1 are generally accordant. Thus measurement of the thickness t of the reacted layer 7 can be an index of wastage of the sintered body. Measurements of thicknesses of reacted layers were therefore carried out with using the sectional SEM images. As shown in FIG. 7B, however, if the secondary crystal 7a were observed, this was omitted from the measurement.

The test results are summarized in Tables 1 through 3. In each table, the second to fourth columns show mixing ratios of ytterbia, alumina and hafnia (zirconia in Table 3) and the fifth column shows the measured thicknesses of the reacted layers.

**Table 1 CMAS-attack test results (binary system)**

| No. | ratio (mol%) | | | reaction thickness (*µ* m) | grade |
|---|---|---|---|---|---|
| | YbO_{1.5} | AlO_{1.5} | HfO₂ | | |
| 1 | 94.7 | 0.0 | 5.3 | 48.5 | Δ |
| 2 | 82.4 | 0.0 | 17.6 | 90.0 | Δ |
| 3 | 66.7 | 0.0 | 33.3 | 50.5 | Δ |
| 4 | 66.7 | 0.0 | 33.3 | 53.3 | Δ |
| 5 | 46.2 | 0.0 | 53.8 | 358.5 | × |
| 6 | 90.0 | 10.0 | 0.0 | 61.5 | Δ |
| 7 | 85.0 | 15.0 | 0.0 | 45.0 | Δ |
| 8 | 85.0 | 15.0 | 0.0 | 41.0 | Δ |
| 9 | 80.0 | 20.0 | 0.0 | 39.9 | Δ |
| 10 | 70.0 | 30.0 | 0.0 | 17.5 | ○ |
| 11 | 66.7 | 33.3 | 0.0 | 28.0 | ○ |
| 12 | 60.0 | 40.0 | 0.0 | 17.1 | ○ |
| 13 | 50.0 | 50.0 | 0.0 | 11.6 | ○ |
| 14 | 50.0 | 50.0 | 0.0 | 22.0 | ○ |
| 15 | 45.0 | 55.0 | 0.0 | 18.0 | ○ |
| 16 | 37.5 | 62.5 | 0.0 | 386.0 | × |

Table 1 summarizes results for the binary system. In the test pieces with mole fractions of 0.5 or higher (No. 1-4 and 6-14), the thicknesses of the reaction layers are less than 100 µm. In the test pieces only of ytterbia and hafnia (No. 1-5), the thicknesses of the reaction layers are above 40 µm. In the test pieces only of ytterbia and alumina (No. 6-16), the thicknesses of the reaction layers depend on the mixing ratio and, particularly in the range where the mole fractions of alumina are from 0.3 to 0.5 (No. 10-15), the thicknesses are less than 30 µm. As described already, however, these layers are thin but coarse and it is therefore unclear whether they can achieve long-term CMAS-attack resistance.

**Table 2 CMAS-attack test results (ternary system)**

| No. | ratio (mol%) | | | reaction thickness (*µ* m) | grade |
|---|---|---|---|---|---|
| | YbO_{1.5} | AlO_{1.5} | HfO₂ | | |
| 17 | 89.5 | 5.3 | 5.3 | 66.0 | Δ |
| 18 | 89.5 | 5.3 | 5.3 | 36.1 | Δ |
| 19 | 87.2 | 10.3 | 2.6 | 72.5 | Δ |
| 20 | 87.2 | 10.3 | 2.6 | 43.6 | Δ |
| 21 | 86.5 | 5.4 | 8.1 | 51.0 | Δ |
| 22 | 83.3 | 5.6 | 11.1 | 48.0 | Δ |
| 23 | 82.1 | 15.4 | 2.6 | 64.0 | Δ |
| 24 | 81.1 | 10.8 | 8.1 | 46.5 | Δ |
| 25 | 80.0 | 5.7 | 14.3 | 66.5 | Δ |
| 26 | 78.9 | 15.8 | 5.3 | 55.0 | Δ |
| 27 | 77.8 | 11.1 | 11.1 | 65.0 | Δ |
| 28 | 76.5 | 5.9 | 17.6 | 58.5 | Δ |
| 29 | 75.7 | 16.2 | 8.1 | 48.5 | Δ |
| 30 | 74.3 | 11.4 | 14.3 | 55.5 | Δ |
| 31 | 72.7 | 6.1 | 21.2 | 75.5 | Δ |
| 32 | 71.8 | 25.6 | 2.6 | 21.2 | ○ |
| 33 | 71.2 | 19.2 | 9.6 | 34.5 | Δ |
| 34 | 70.6 | 11.8 | 17.6 | 63.5 | Δ |
| 35 | 68.6 | 17.1 | 14.3 | 72.5 | Δ |
| 36 | 66.7 | 22.2 | 11.1 | 13.9 | ○ |
| 37 | 66.7 | 30.8 | 2.6 | 27.0 | ○ |
| 38 | 66.7 | 12.1 | 21.2 | 92.0 | Δ |
| 39 | 64.7 | 17.6 | 17.6 | 7.6 | ○ |
| 40 | 64.7 | 17.6 | 17.6 | 7.6 | ○ |
| 41 | 63.2 | 31.6 | 5.3 | 13.3 | ○ |
| 42 | 62.5 | 12.5 | 25.0 | 71.0 | Δ |
| 43 | 62.0 | 25.4 | 12.7 | 8.2 | ○ |
| 44 | 62.0 | 25.4 | 12.7 | 8.2 | ○ |
| 45 | 61.1 | 21.8 | 11.1 | 6.8 | ○ |
| 46 | 61.1 | 27.8 | 11.1 | 6.8 | ○ |
| 47 | 59.5 | 32.4 | 8.1 | 5.9 | ○ |
| 48 | 59.5 | 32.4 | 8.1 | 8.8 | ○ |
| 49 | 59.5 | 32.4 | 8.1 | 5.9 | ○ |
| 50 | 59.5 | 32.4 | 8.1 | 8.8 | ○ |
| 51 | 58.8 | 23.5 | 17.6 | 5.5 | ○ |
| 52 | 58.8 | 23.5 | 17.6 | 5.5 | ○ |
| 53 | 58.1 | 12.9 | 29.0 | 71.2 | Δ |
| 54 | 57.9 | 36.8 | 5.3 | 8.4 | ○ |
| 55 | 57.9 | 36.8 | 5.3 | 8.4 | ○ |
| 56 | 55.6 | 33.3 | 11.1 | 7.0 | ○ |
| 57 | 55.6 | 33.3 | 11.1 | 7.0 | ○ |
| 58 | 54.5 | 24.2 | 21.2 | 9.1 | ○ |
| 59 | 54.1 | 37.8 | 8.1 | 9.1 | ○ |
| 60 | 54.1 | 37.8 | 8.1 | 9.1 | ○ |
| 61 | 52.6 | 42.1 | 5.3 | 8.1 | ○ |
| 62 | 52.6 | 42.1 | 5.3 | 8.1 | ○ |
| 63 | 51.2 | 32.6 | 16.3 | 8.3 | ○ |
| 64 | 51.2 | 32.6 | 16.3 | 8.3 | ○ |
| 65 | 50.0 | 30.0 | 20.0 | 442.0 | × |
| 66 | 50.0 | 38.9 | 11.1 | 15.5 | ○ |
| 67 | 50.0 | 38.9 | 11.1 | 21.5 | ○ |
| 68 | 50.0 | 38.9 | 11.1 | 15.5 | ○ |
| 69 | 47.5 | 27.5 | 25.0 | 649.0 | × |
| 70 | 47.5 | 17.5 | 35.0 | 335.0 | × |
| 71 | 47.4 | 47.4 | 5.3 | 121.0 | × |
| 72 | 47.1 | 35.3 | 17.6 | 109.5 | × |
| 73 | 42.9 | 14.3 | 42.9 | 67.0 | Δ |
| 74 | 42.5 | 42.5 | 15.0 | 535.0 | × |
| 75 | 40.0 | 50.0 | 10.0 | 608.0 | × |
| 76 | 40.0 | 40.0 | 20.0 | 485.0 | × |
| 77 | 37.5 | 37.5 | 25.0 | 62.0 | Δ |
| 78 | 30.0 | 30.0 | 40.0 | 256.0 | × |
| 79 | 27.5 | 57.5 | 15.0 | 631.0 | × |
| 80 | 22.2 | 66.7 | 11.1 | 59.5 | Δ |
| 81 | 20.0 | 20.0 | 60.0 | 260.0 | × |
| 82 | 20.0 | 50.0 | 30.0 | 370.0 | × |
| 83 | 10.0 | 40.0 | 50.0 | 636.0 | × |
| 84 | 10.0 | 60.0 | 30.0 | 699.0 | × |

In the ternary system (No. 17-84) of ytterbia, alumina and hafnia, the thicknesses of the reacted layers, with few limited exceptions, are less than 100 µm provided that the mole fractions of ytterbia are generally 0.5 or greater. Particularly in the range 0.8 or less (No. 25-68), the thicknesses tend to be smaller. Generally these pieces give thin reacted layers as compared with those by the binary system (Table 1) and are therefore expected to be superior in light of the CMAS-attack resistance. Among them, the test pieces with mole fractions of alumina over 0.2 (No. 32, 36, 37, 41, 43-52 and 54-68) tend to form further thinner reacted layers.

**Table 3 CMAS-attack test results (ternary system including zirconia)**

| No. | ratio (mol%) | | | reaction thickness (*µ* m) | grade |
|---|---|---|---|---|---|
| | YbO_{1.5} | AlO_{1.5} | ZrO₂ | | |
| 85 | 80.0 | 0.0 | 20.0 | 52.6 | Δ |
| 86 | 70.0 | 0.0 | 30.0 | 57.2 | Δ |
| 87 | 70.0 | 10.0 | 20.0 | 63.1 | Δ |
| 88 | 65.0 | 10.0 | 25.0 | 65.9 | Δ |
| 89 | 60.0 | 10.0 | 30.0 | 71.1 | Δ |
| 90 | 60.0 | 0.0 | 40.0 | 54.1 | Δ |
| 91 | 60.0 | 20.0 | 20.0 | 18.3 | ○ |
| 92 | 60.0 | 10.0 | 30.0 | 65.1 | Δ |
| 93 | 60.0 | 20.0 | 20.0 | 18.3 | ○ |
| 94 | 55.0 | 15.0 | 30.0 | 9.2 | ○ |
| 95 | 50.0 | 25.0 | 25.0 | 9.6 | ○ |
| 96 | 50.0 | 30.0 | 20.0 | 11.2 | ○ |
| 97 | 50.0 | 10.0 | 40.0 | 13.3 | ○ |
| 98 | 50.0 | 25.0 | 25.0 | 11.9 | ○ |
| 99 | 50.0 | 30.0 | 20.0 | 9.5 | ○ |
| 100 | 50.0 | 10.0 | 40.0 | 15.9 | ○ |
| 101 | 50.0 | 25.0 | 25.0 | 10.9 | ○ |
| 102 | 44.0 | 28.0 | 28.0 | 12.3 | ○ |
| 103 | 40.0 | 30.0 | 30.0 | 430.8 | × |
| 104 | 35.0 | 32.5 | 32.5 | 586.8 | × |

In the test pieces of the ternary system where hafnia is replaced with zirconia (No. 85-104), similar relations can be acknowledged.

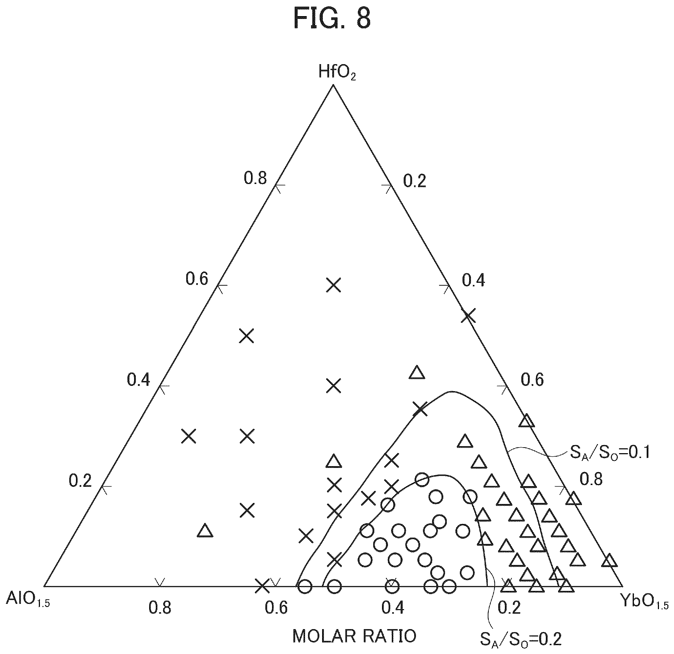

FIG. 8 shows a ternary diagram on which test results about the test pieces listed in Tables 1 and 2 are plotted. Circles represent the results in which the thicknesses of the reacted layers are in the range of 0-30 µm, triangles represent those in which the thickness are in the range of 30-100 µm and crosses represent those in which the thickness are more than 100 µm. As described already, it is understood that those satisfying 1>a≥0.5, b>0 and c=1-(a+b), where the compositions are represented by the formula a(YbO_{1.5})b(AlO_{1.5})c(HfO₂), are expected to have relatively superior CMAS-attack resistance. Yb may be of course replaced partially or totally with another rare-earth element, and such an example is Lu. Hf can be partially or totally replaced with another group 4 transition element, and such an example is Zr.

If the S_{A}/S₀ ratios obtained by the equilibrium calculation at 1500 degrees C as described already are laid over FIG. 8, one can gain better understandings about the preferable composition range that provides better CMAS-attack resistance. It is understood that, as the value S_{A}/S₀ is larger, generally the corresponding range provides better CMAS-attack resistance. Preferably S_{A}/S₀≥0.1 and more preferably S_{A}/S₀≥0.2. From the observation on the reaction products, however, as described already, the case where hafnia (or zirconia) is not contained (specifically, c=0) should be excluded and therefore preferably c>0 should be satisfied.

Although certain embodiments have been described above, modifications and variations of the embodiments described above will occur to those skilled in the art, in light of the above teachings.

### INDUSTRIAL APPLICABILITY

The disclosed art provides a coating capable of protecting ceramic-matrix composites against a high-temperature environment including dust over a long term.

## Claims

1. A coating for protecting a ceramic-matrix composite against a high-temperature environment including dust, comprising:
a top layer of a substance represented by a formula a(ReO_{1.5})b(AlO_{1.5})c(TrO₂) as an average composition at least on a face exposed to the environment, wherein a, b and c satisfy 1>a≥0.5, b>0 and c=1-(a+b), Re is one or more selected from rare earth elements, and Tr is Hf or Zr.

2. The coating of claim 1, wherein aluminum in the substance forms one or more chemical compounds selected from Re₄Al₂O₉, ReAlO₃ and Re₃Al₅O₁₂.

3. The coating of claim 1, wherein a, b and c further satisfy a formula of S_{A}/S₀≥0.1 wherein S_{A}/S₀ is an area ratio of a region where a mixture of apatite and garnet is stable to a region from Ca/Si=0.11 to Ca/Si=1.5 on a phase diagram for a system of CMAS and the substance at 1500 degrees C.

4. The coating of claim 1, wherein a, b and c further satisfy a formula of S_{A}/S₀≥0.2 wherein S_{A}/S₀ is an area ratio of a region where a mixture of apatite and garnet is stable to a region from Ca/Si=0.11 to Ca/Si=1.5 on a phase diagram for a system of CMAS and the substance at 1500 degrees C.

5. The coating of claim 1, wherein b further satisfies a formula of b>0.2.

6. The coating of any one of claims 1 through 5, wherein Re is one or more selected from Yb and Lu, and Tr is Hf.
